# EUROPÄISCHE PATENTSCHRIFT

(11) **EP 3 696 625 B1**
(45) Veröffentlichungstag und Bekanntmachung des Hinweises auf die Patenterteilung: **13.04.2022**
(21) Anmeldenummer: 19157518.2
(22) Anmeldetag: 15.02.2019
(51) Int. Cl.: G05B 19/042

(54) **ANALOG-EINGABEBAUGRUPPE**
ANALOG INSTALLATION MODULE
MODULE D'ENTRÉE ANALOGIQUE

(43) Veröffentlichungstag der Anmeldung: 19.08.2020
(73) Patentinhaber: Siemens Aktiengesellschaft, 80333 München (DE)
(72) Erfinder: Griesbaum, Wilhelm, 76829 Landau (DE); Lehmann, Ulrich, 76744 Wörth (DE)

(56) Entgegenhaltungen:
- EP-A1- 2 090 945
- DE-A1-102004 009 612
- DE-A1-102013 111 888
- DE-A1-102015 102 581

## Beschreibung

Die vorliegende Erfindung geht aus von einer Baugruppe für eine speicherprogrammierbare Steuerung,
- wobei die Baugruppe mehrere analoge Eingangskanäle für jeweils ein analoges Eingangssignal aufweist,
- wobei die Baugruppe eine Steuer- und Auswertungseinrichtung und für jeden Eingangskanal - jeweils unabhängig von den anderen Eingangskanälen - Eingangsanschlüsse zum Zuführen des jeweiligen analogen Eingangssignals aufweist.

Derartige Baugruppen sind allgemein bekannt. Sie weisen in der Regel einen zentralen Analog-Digital-Konverter auf, der über einen Analogmultiplexer sequenziell nacheinander an die Eingangsanschlüsse der Eingangskanäle angeschaltet wird. Dies führt zu einem erheblichen Hardwareaufwand, insbesondere aufgrund der möglichen Potenzialunterschiede von bis zu 120 V DC oder 150 V AC zwischen den verschiedenen Eingangsanschlüssen. Eine Zertifizierung gemäß einem SIL-Niveau entsprechend der IEC 61508 ist schwierig.

In der EP 2 090 945 A1 ist eine Eingabebaugruppe zur Erfassung analoger Messwerte offenbart.

In der DE 10 2013 111 888 A1 ist eine Sicherheitsvorrichtung zum mehrkanaligen Verarbeiten wenigstens eines analogen Eingangssignals offenbart.

Die DE 10 2004 009 612 A1 offenbart eine Schaltungsanordnung zum Verzögerungsabgleich von zeitversetzt arbeitenden Analog-Digital-Wandlern.

Die DE 19 2915 102 581 A1 offenbart eine IC-Sensordiagnostik unter Verwendung mehrerer Kommunikationssignalwege.

Die Aufgabe der vorliegenden Erfindung besteht darin, eine Baugruppe für eine speicherprogrammierbare Steuerung zu schaffen, welche auf einfache und zuverlässige Weise eine Zertifizierung gemäß einem SIL-Niveau entsprechend der IEC 61508 ermöglicht.

Die Aufgabe wird durch eine Baugruppe mit den Merkmalen des Anspruchs 1 gelöst. Vorteilhafte Ausgestaltungen der erfindungsgemäßen Baugruppe sind Gegenstand der abhängigen Ansprüche 2 bis 13.

Erfindungsgemäß wird eine Baugruppe der eingangs genannten Art dadurch ausgestaltet,
- dass die Baugruppe für jeden Eingangskanal - jeweils unabhängig von den anderen Eingangskanälen - einen ersten und einen zweiten Analog-Digital-Konverter, ein erstes, ein zweites, ein drittes und ein viertes Koppelelement und eine Umschalteinrichtung aufweist,
- dass die Steuer- und Auswertungseinrichtung für jeden Eingangskanal - jeweils unabhängig von den anderen Eingangskanälen - eine Auswertungsschaltung, einen Testsignalgenerator und einen Umschaltsignalgenerator aufweist,
- dass eine Eingangsseite des jeweiligen ersten Analog-Digital-Konverters direkt oder indirekt mit den jeweiligen Eingangsanschlüssen und eine Ausgangsseite des jeweiligen ersten Analog-Digital-Konverters über das jeweilige erste Koppelelement mit der jeweiligen Auswertungsschaltung verbunden ist,
- dass die jeweilige Umschalteinrichtung einen ersten und einen zweiten Signaleingang, einen Signalausgang und einen Steuereingang aufweist,
- dass der erste Signaleingang der jeweiligen Umschalteinrichtung direkt oder indirekt mit den jeweiligen Eingangsanschlüssen verbunden ist, der zweite Signaleingang der jeweiligen Umschalteinrichtung über das jeweilige dritte Koppelelement mit dem jeweiligen Testsignalgenerator verbunden ist, der Steuereingang der jeweiligen Umschalteinrichtung über das jeweilige vierte Koppelelement mit dem jeweiligen Umschaltsignalgenerator verbunden ist und der Signalausgang der jeweiligen Umschalteinrichtung mit einer Eingangsseite des jeweiligen zweiten Analog-Digital-Konverters verbunden ist,
- dass eine Ausgangsseite des jeweiligen zweiten Analog-Digital-Konverters über das jeweilige zweite Koppelelement mit der jeweiligen Auswertungsschaltung verbunden ist und
- dass das jeweilige erste, das jeweilige zweite, das jeweilige dritte und das jeweilige vierte Koppelelement jeweils als eine Potenzialtrennung bewirkendes Koppelelement ausgebildet sind.

Mit den Ausgestaltungen der Eingangskanäle und der Steuerund Auswertungseinrichtung können ohne weitere Spezifikationen die Sicherheitsniveaus SIL 1 und SIL 2 gemäß der IEC 61508 erreicht werden. Für detailierte Ausführungen, wie die erfindungsgemäße Baugruppe die obenstehende Aufgabe löst, sei auf die Beschreibung der Figuren verwiesen. Vorzugsweise ist die Steuer- und Auswertungseinrichtung in einem FPGA angeordnet. Dadurch kann die Steuer- und Auswertungseinrichtung auf kostengünstige Weise hergestellt werden. Vorzugsweise weist die Steuer- und Auswertungseinrichtung für den jeweiligen Eingangskanal eine jeweilige Empfangseinrichtung auf, die mit einer Ausgangsseite des jeweiligen ersten oder des jeweiligen zweiten Koppelelements verbunden ist und aus einem über das jeweilige erste oder das jeweilige zweite Koppelelement übertragenen digitalen Signal ein jeweiliges frequenzkodiertes Empfangssignal ausfiltert. Dadurch ist es auf einfache Weise möglich, einen sogenannten HART-Empfänger zu realisieren.

Vorzugsweise ist weiterhin vorgesehen,
- dass die Steuer- und Auswertungseinrichtung für den jeweiligen Eingangskanal eine jeweilige Sendeeinrichtung aufweist,
- dass die jeweilige Sendeeinrichtung über ein jeweiliges fünftes Koppelelement mit den jeweiligen Eingangsanschlüssen verbunden ist,
- dass die jeweilige Sendeeinrichtung in das jeweilige Eingangssignal ein jeweiliges frequenzkodiertes Sendesignal einspeist und
- dass das jeweilige fünfte Koppelelement als eine Potenzialtrennung bewirkendes Koppelelement ausgebildet ist.

Dadurch ist es auf einfache Weise möglich, einen sogenannten HART-Sender zu realisieren.

Vorzugsweise ist vorgesehen,
- dass die Baugruppe eine erste Stromversorgungseinrichtung aufweist, welche die Steuer- und Auswertungseinrichtung mit elektrischer Energie versorgt,
- dass die erste Stromversorgungseinrichtung über ein sechstes Koppelelement mit einer zweiten Stromversorgungseinrichtung verbunden ist,
- dass die zweite Stromversorgungseinrichtung den ersten und den zweiten Analog-Digital-Konverter mindestens eines der Eingangskanäle mit elektrischer Energie versorgt und
- dass das sechste Koppelelement als eine Potenzialtrennung bewirkendes Koppelelement ausgebildet ist.

Dadurch ist auf einfache Weise eine potenzialgetrennte Energieversorgung der einzelnen Elemente des jeweiligen Eingangskanals möglich.

Vorzugsweise ist vorgesehen, dass die jeweilige Auswertungsschaltung
- eine jeweilige erste und eine jeweilige zweite Filtereinrichtung zum Ermitteln eines jeweiligen ersten und eines jeweiligen zweiten gefilterten Signals anhand eines von dem jeweiligen ersten und dem jeweiligen zweiten Analog-Digital-Konverter ausgegebenen jeweiligen digitalen Signals aufweist,
- eine jeweilige erste Vergleichseinrichtung zum Vergleichen des jeweiligen ersten und des jeweiligen zweiten gefilterten Signals aufweist und
- eine jeweilige zweite Vergleichseinrichtung zum Vergleichen eines von dem jeweiligen Testsignalgenerator ausgegebenen jeweiligen Testsignals und des jeweiligen zweiten gefilterten Signals aufweist.

Dadurch kann auf einfache und zuverlässige Weise bereits innerhalb der Steuer- und Auswertungseinrichtung nicht nur eine gegenseitige Überwachung der über die beiden jeweiligen Analog-Digital-Konverter ausgegebenen digitalen Signale erfolgen, sondern es kann zusätzlich auch eine Überprüfung der Analog-Digital-Konverter erfolgen.

Ein von dem jeweiligen ersten und dem jeweiligen zweiten Analog-Digital-Konverter ausgegebenes jeweiliges digitales Signal liegt in aller Regel innerhalb eines jeweiligen vorbestimmten Wertebereichs. Vorzugsweise ist der jeweilige Testsignalgenerator derart ausgebildet, dass ein von dem jeweiligen Testsignalgenerator ausgegebenes jeweiliges Testsignal zyklisch den gesamten jeweiligen vorbestimmten Wertebereich durchläuft. Dadurch kann der zweite Analog-Digital-Konverter über seinen vollen Wertebereich geprüft werden.

Es ist möglich, dass der jeweilige Testsignalgenerator und der jeweilige Umschaltsignalgenerator derart aufeinander abgestimmt sind, dass
- zunächst das jeweilige Testsignal über den jeweiligen zweiten Signaleingang der jeweiligen Umschalteinrichtung direkt oder indirekt dem jeweiligen zweiten Analog-Digital-Konverter zugeführt wird,
- sodann das jeweilige Testsignal den gesamten jeweiligen vorbestimmten Wertebereich durchläuft und
- erst danach wieder das jeweilige analoge Eingangssignal direkt oder indirekt dem jeweiligen zweiten Analog-Digital-Konverter zugeführt wird.

In diesem Fall wird der zweite Analog-Digital-Konverter bei jeder einzelnen Testphase vollständig überprüft.

Alternativ ist es möglich, dass der jeweilige Testsignalgenerator und der jeweilige Umschaltsignalgenerator derart aufeinander abgestimmt sind, dass
a) zunächst das jeweilige Testsignal über den jeweiligen zweiten Signaleingang der jeweiligen Umschalteinrichtung direkt oder indirekt dem jeweiligen zweiten Analog-Digital-Konverter zugeführt wird,
b) sodann das jeweilige Testsignal jeweils einen Teil des gesamten jeweiligen vorbestimmten Wertebereichs durchläuft,
c) danach wieder das jeweilige analoge Eingangssignal direkt oder indirekt dem jeweiligen zweiten Analog-Digital-Konverter zugeführt wird und
d) die Schritte a) bis c) wiederholt ausgeführt werden und bei der jeweiligen Ausführung des Schrittes b) das jeweilige Testsignal jeweils einen anderen Teil des gesamten jeweiligen vorbestimmten Wertebereichs durchläuft, bis das jeweilige Testsignal aufgrund der wiederholten Ausführung des Schrittes b) den gesamten jeweiligen vorbestimmten Wertebereich durchlaufen hat.

In diesem Fall werden zum vollständigen Überprüfen des zweiten Analog-Digital-Konverters zwar mehrere Testphasen entsprechend dem Schritt b) benötigt. Die einzelnen Testphasen können dafür aber kürzer gewählt werden.

Vorzugsweise ist der jeweilige erste Analog-Digital-Konverter als Delta-Sigma-Modulator ausgebildet und weist das jeweilige erste Koppelelement zusätzlich zu einem Vorwärtskanal zur Übertragung eines von dem jeweiligen ersten Analog-Digital-Konverter abgegebenen jeweiligen digitalen Signals einen Rückwärtskanal zur Übertragung eines jeweiligen Taktsignals von der jeweiligen Auswertungsschaltung zum jeweiligen ersten Analog-Digital-Konverter auf. Dies stellt eine einfache, zuverlässige, kostengünstige und robuste Ausgestaltung für den jeweiligen ersten Analog-Digital-Konverter dar. Alternativ oder zusätzlich kann auch für den jeweiligen zweiten Analog-Digital-Konverter und das zugehörige jeweilige zweite Koppelelement eine entsprechende Ausgestaltung vorgesehen werden.

Vorzugsweise sind der jeweilige erste und der jeweilige zweite Analog-Digital-Konverter diversitär ausgebildet. Dadurch können systematische Fehler besonders zuverlässig vermieden werden.

Um eine diversitäre Ausgestaltung zu realisieren, ist es möglich, dass, bezogen auf den jeweiligen ersten und den jeweiligen zweiten Analog-Digital-Konverter, einer dieser beiden Analog-Digital-Konverter als Delta-Sigma-Modulator ausgebildet ist und das mit diesem Analog-Digital-Konverter verbundene Koppelelement zusätzlich zu einem Vorwärtskanal zur Übertragung eines von diesem Analog-Digital-Konverter abgegebenen digitalen Signals einen Rückwärtskanal zur Übertragung eines Taktsignals von der jeweiligen Auswertungsschaltung zu diesem Analog-Digital-Konverter aufweist. Alternativ oder zusätzlich ist es zur Realisierung einer diversitären Ausgestaltung möglich, dass der andere dieser beiden Analog-Digital-Konverter als SAR-Analog-Digital-Konverter ausgebildet ist und das mit diesem Analog-Digital-Konverter verbundene Koppelelement zusätzlich zu einem Vorwärtskanal zur Übertragung eines von diesem Analog-Digital-Konverter abgegebenen digitalen Signals drei Rückwärtskanäle zur Übertragung eines Taktsignals, eines Konfigurationssignals und eines Datenrahmensignals von der jeweiligen Auswertungsschaltung zu diesem Analog-Digital-Konverter aufweist.

Sofern für den einen Analog-Digital-Konverter die eine Ausgestaltung und für den anderen Analog-Digital-Konverter die andere Ausgestaltung gewählt wird, ergibt sich die diversitäre Ausgestaltung ganz von selbst. Sofern nur für den einen oder nur für den anderen Analog-Digital-Konverter die eine bzw. die andere Ausgestaltung gewählt wird, kann der jeweils noch diversitär auszugestaltende jeweilige Analog-Digital-Konverter auf beliebige andere Weise ausgestaltet sein.

Vorzugsweise sind das jeweilige erste, das jeweilige zweite, das jeweilige dritte und das jeweilige vierte Koppelelement als Induktivkoppler ausgebildet sind. Diese Ausgestaltung ist robust, kostengünstig und zuverlässig.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen industriellen technischen Prozess und eine speicherprogrammierbare Steuerung,
- FIG 2: eine Baugruppe einer speicherprogrammierbaren Steuerung,
- FIG 3: die Baugruppe von FIG 2 in detaillierterer Darstellung,
- FIG 4: die Analogseite eines Eingangskanals,
- FIG 5: ein Wertediagramm,
- FIG 6: ein Zeitdiagramm,
- FIG 7: ein weiteres Zeitdiagramm,
- FIG 8: eine Ausgestaltung von FIG 3,
- FIG 9: eine weitere Ausgestaltung von FIG 3 und
- FIG 10: mehrere parallel geschaltete Eingangskanäle.

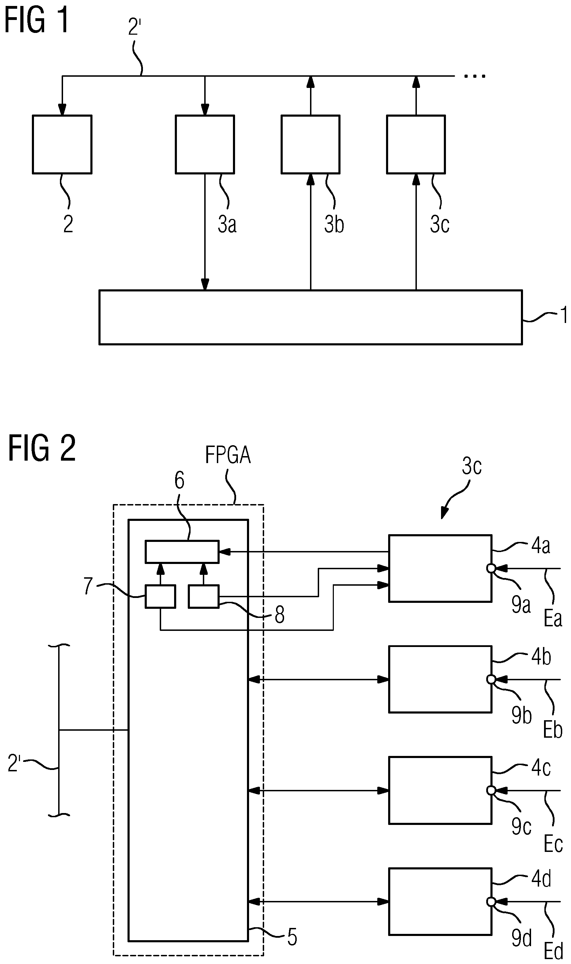

Gemäß FIG 1 wird ein industrieller technischer Prozess 1 von einer speicherprogrammierbaren Steuerung gesteuert. Der industrielle technische Prozess 1 kann beliebiger Natur sein. Beispielsweise kann es sich um eine Chemieanlage, um eine Abfülleinrichtung, eine Spritzgießmaschine, eine Fördereinrichtung und um eine andere Einrichtung oder Anlage handeln. Die speicherprogrammierbare Steuerung umfasst eine Zentraleinheit 2 und Peripheriebaugruppen 3a, 3b usw. Die Zentraleinheit 2 und die Peripheriebaugruppen 3a, 3b usw. sind über ein Bussystem 2' miteinander verbunden. Die Peripheriebaugruppen 3a, 3b usw. können verschiedenartig ausgebildet sein. Beispielsweise kann die Peripheriebaugruppe 3a eine Baugruppe sein, mittels derer digitale Steuersignale an den industriellen technischen Prozess 1 ausgegeben werden. In ähnlicher Weise kann die Peripheriebaugruppe 3b eine Baugruppe sein, mittels derer der speicherprogrammierbaren Steuerung digitale Prozesssignale zugeführt werden. Mindestens eine der Peripheriebaugruppen 3a, 3b usw. - im vorliegenden Fall die Peripheriebaugruppe 3c - ist eine Baugruppe, mittels derer der speicherprogrammierbaren Steuerung analoge Prozesssignale zugeführt werden. Die Peripheriebaugruppe 3c ist der Gegenstand der vorliegenden Erfindung.

Gemäß FIG 2 weist die Baugruppe 3c mehrere analoge Eingangskanäle 4a bis 4d auf. In der Regel sind entsprechend der Darstellung in FIG 2 mindestens vier Eingangskanäle 4a bis 4d vorhanden. Die Anzahl an Eingangskanälen 4a bis 4d kann aber auch größer als vier sein. Beispielsweise kann sie acht oder 16 betragen. Oftmals ist die Anzahl an Eingangskanälen 4a bis 4d eine Potenz von zwei. Mittels jedes der Eingangskanäle 4a bis 4d kann der Baugruppe 3c jeweils ein analoges Eingangssignal Ea bis Ed zugeführt werden. Das jeweilige analoge Eingangssignal Ea bis Ed kann für eine beliebige physikalische Größe stehen, beispielsweise eine Temperatur, einen Druck oder einen Füllstand.

Die Baugruppe 3c weist eine Steuer- und Auswertungseinrichtung 5 auf. Die Steuer- und Auswertungseinrichtung 5 ist einheitlich für alle Eingangskanäle 4a bis 4d einmal vorhanden. Die Steuer- und Auswertungseinrichtung 5 weist für jeden Eingangskanal 4a bis 4d - jeweils unabhängig von den anderen Eingangskanälen 4a bis 4d - eine Auswertungsschaltung 6, einen Testsignalgenerator 7 und einen Umschaltsignalgenerator 8 auf. Die Auswertungsschaltung 6, der Testsignalgenerator 7 und der Umschaltsignalgenerator 8 sind also eigenständig und individuell für jeden einzelnen Eingangskanal 4a bis 4d vorhanden. Dargestellt sind in FIG 2 die Auswertungsschaltung 6, der Testsignalgenerator 7 und der Umschaltsignalgenerator 8 nur für den Eingangskanal 4a.

Die Steuer- und Auswertungseinrichtung 5 kann entsprechend der Darstellung in FIG 2 beispielsweise in einem FPGA angeordnet sein. Der Begriff "FPGA" (field programmable gate array) ist Fachleuten allgemein geläufig. Es handelt sich um eine elektronische Baueinheit, bei welcher durch eine entsprechende Programmierung die Hardware-Verschaltung der einzelnen Elemente des FPGA festgelegt werden kann.

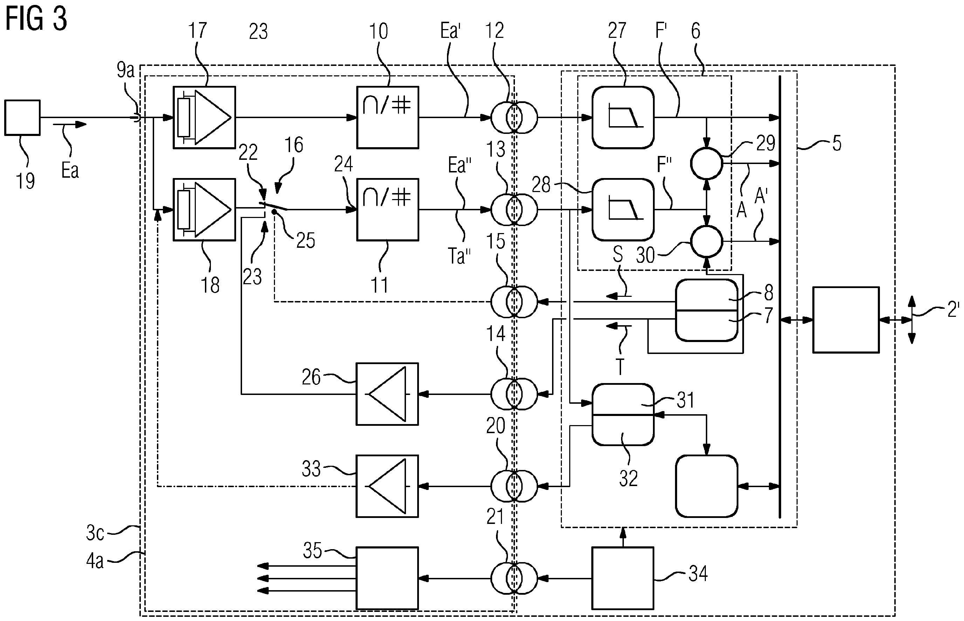

Die Baugruppe 3c weist entsprechend der Darstellung in FIG 2 weiterhin für jeden Eingangskanal 4a bis 4d - jeweils unabhängig von den anderen Eingangskanälen 4a bis 4d Eingangsanschlüsse 9a bis 9d auf. Über die Eingangsanschlüsse 9a bis 9d kann dem jeweiligen Eingangskanal 4a bis 4d das jeweilige analoge Eingangssignal Ea bis Ed zugeführt werden. Weiterhin weist die Baugruppe 3c entsprechend der Darstellung in FIG 3 für jeden Eingangskanal 4a bis 4d - jeweils unabhängig von den anderen Eingangskanälen 4a bis 4d - einen ersten und einen zweiten Analog-Digital-Konverter 10, 11, ein erstes, ein zweites, ein drittes und ein viertes Koppelelement 12 bis 15 und eine Umschalteinrichtung 16 auf. Dargestellt ist dies in den FIG 3 nur für den Eingangskanal 4a.

Nachfolgend werden in Verbindung mit FIG 3 und auch den weiteren FIG lediglich der Aufbau und die Wirkungsweise des Eingangskanals 4a erläutert. Auch wird lediglich für den Eingangskanal 4a das Zusammenwirken mit der Steuer- und Auswertungseinrichtung 5 erläutert. Die entsprechenden Ausführungen gelten aber in analoger Weise auch für die anderen Eingangskanäle 4b bis 4d.

Das analoge Eingangssignal Ea kann ein Spannungssignal sein. In der Regel handelt es sich jedoch um ein Stromsignal. In diesem Fall liegt das Stromsignal in der Regel im Bereich von 4 bis 20 mA. Dies ist jedoch von untergeordneter Bedeutung.

Es könnte auch in einem anderen Bereich liegen, beispielsweise im Bereich von -24 mA bis +24 mA.

Entsprechend der Darstellung in FIG 3 ist eine Eingangsseite des ersten Analog-Digital-Konverters 10 direkt oder indirekt mit den Eingangsanschlüssen 9a verbunden. Eine direkte Verbindung liegt in der Regel vor, wenn das analoge Eingangssignal Ea ein Spannungssignal ist. Wenn das analoge Eingangssignal Ea hingegen ein Stromsignal ist, ist zwischen den Eingangsanschlüssen 9a und dem ersten Analog-Digital-Konverter 10 ein Strom-Spannung-Wandler 17 angeordnet. In diesem Sinne ist die Formulierung "direkt oder indirekt" im Rahmen der vorliegenden Erfindung zu verstehen. Eine indirekte Verbindung liegt vor, wenn das jeweilige Signal über einen Strom-Spannung-Wandler 17, 18 geführt wird. Wird das jeweilige Signal nicht über einen Strom-Spannung-Wandler 17, 18 geführt, liegt eine direkte Verbindung vor.

Eine Ausgangsseite des ersten Analog-Digital-Konverters 10 ist über das erste Koppelelement 12 mit der Auswertungsschaltung 6 verbunden. Das mittels eines Sensors 19 generierte analoge Eingangssignal Ea wird dadurch - gegebenenfalls nach einer Strom-Spannung-Wandlung - in dem ersten Analog-Digital-Konverter 10 digitalisiert. Das zugehörige digitale Signal Ea' wird über das erste Koppelelement 12 der Auswertungsschaltung 6 zugeführt.

Das erste Koppelelement 12 ist derart ausgebildet, dass es eine Potenzialtrennung bewirkt. Beispielsweise kann das erste Koppelelement 12 als Optokoppler ausgebildet sein. Vorzugsweise ist das erste Koppelelement 12 jedoch als Induktivkoppler ausgebildet. Beispiele geeigneter Induktivkoppler - manchmal auch als Magnetkoppler bezeichnet - sind Fachleuten allgemein bekannt. Rein beispielhaft kann auf die Induktivkoppler der Typen ADuM1201 und ADuM1412 der Firma Analog Devices verwiesen werden. Induktivkoppler weisen insbesondere den Vorteil auf, dass sie eine hohe Übertragungsgeschwindigkeit (Bitrate) ermöglichen und hohe Isolationsspannungen (oftmals oberhalb von 2 kV) aufweisen. Das zweite bis vierte Koppelelement 13 bis 15 (und auch ein später noch eingeführtes fünftes Koppelelement 20 und ein später noch eingeführtes sechstes Koppelelement 21) sind gleichartig ausgebildet.

Entsprechend der Darstellung in FIG 3 ist weiterhin eine Eingangsseite des zweiten Analog-Digital-Konverters 11 ebenfalls mit den Eingangsanschlüssen 9a verbunden. Zwischen den Eingangsanschlüssen 9a und dem zweiten Analog-Digital-Konverter 11 ist jedoch die Umschalteinrichtung 16 angeordnet. Die Umschalteinrichtung 16 wiederum weist einen ersten Signaleingang 22, einen zweiten Signaleingang 23, einen Signalausgang 24 und einen Steuereingang 25 auf.

Der erste Signaleingang 22 ist direkt oder indirekt mit den Eingangsanschlüssen 9a verbunden. Eine direkte Verbindung liegt in der Regel vor, wenn das analoge Eingangssignal Ea ein Spannungssignal ist. Wenn das analoge Eingangssignal Ea ein Stromsignal ist, kann ebenfalls eine direkte Verbindung vorliegen. In diesem Fall kann der gegebenenfalls erforderliche Strom-Spannung-Wandler 18 zwischen der Umschalteinrichtung 16 und dem zweiten Analog-Digital-Konverter 11 angeordnet sein. Alternativ kann eine indirekte Verbindung vorliegen, nämlich dann, wenn entsprechend der Darstellung in FIG 3 der Strom-Spannung-Wandler 18 zwischen den Eingangsanschlüssen 9a und der Umschalteinrichtung 16 angeordnet ist.

Der Signalausgang 25 der Umschalteinrichtung 16 ist mit einer Eingangsseite des zweiten Analog-Digital-Konverters 11 verbunden. Analog zur Verbindung des ersten Signaleingangs 22 mit den Eingangsanschlüssen 9a kann die Verbindung alternativ direkt oder - falls der Strom-Spannung-Wandler 18 zwischen der Umschalteinrichtung 16 und dem zweiten Analog-Digital-Konverter 11 angeordnet ist - indirekt sein.

Eine Ausgangsseite des zweiten Analog-Digital-Konverters 11 ist über das zweite Koppelelement 13 mit der Auswertungsschaltung 6 verbunden. Sofern innerhalb der Umschalteinrichtung 16 der erste Signaleingang 22 mit dem Signalausgang 24 verbunden ist, wird dadurch das mittels des Sensors 19 generierte analoge Eingangssignal Ea - gegebenenfalls nach einer Strom-Spannung-Wandlung - in dem zweiten Analog-Digital-Konverter 11 digitalisiert. Das zugehörige digitale Signal Ea" wird über das zweite Koppelelement 13 der Auswertungsschaltung 6 zugeführt.

Der zweite Signaleingang 23 ist über das dritte Koppelelement 14 mit dem Testsignalgenerator 7 verbunden. Gegebenenfalls kann zwischen dem dritten Koppelelement 14 und dem zweiten Signaleingang 23 eine erste Verstärker- und Umsetzeinrichtung 26 angeordnet sein. Sofern innerhalb der Umschalteinrichtung 16 der zweite Signaleingang 23 mit dem Signalausgang 24 verbunden ist, wird dadurch das mittels des Testsignalgenerators 7 generierte Testsignal T - gegebenenfalls nach einer Strom-Spannung-Wandlung - in dem zweiten Analog-Digital-Konverter 11 digitalisiert. In diesem Fall wird über das zweite Koppelelement 13 das hiermit korrespondierende digitale Signal Ta" der Auswertungsschaltung 6 zugeführt.

Der Steuereingang 25 ist über das vierte Koppelelement 15 mit dem Umschaltsignalgenerator 8 verbunden. Der Umschaltsignalgenerator 8 generiert das entsprechende Steuersignal S, durch das festgelegt wird, ob der erste oder der zweite Signaleingang 22, 23 mit dem Signalausgang 24 verbunden werden soll.

Das Testsignal T wird also nicht permanent dem zweiten Analog-Digital-Konverter 11 zugeführt, sondern nur dann, wenn aufgrund einer entsprechenden Ansteuerung der Umschalteinrichtung 16 durch den Umschaltsignalgenerator 8 der zweite Signaleingang 23 auf den Signalausgang 24 durchgeschaltet ist. Dies ist nur temporär der Fall. Es wird also alternierend immer wieder zwischen einem Durchschalten des ersten Signaleingangs 22 auf den Signalausgang 24 und einem Durchschalten des zweiten Signaleingangs 23 auf den Signalausgang 24 hin und her gewechselt. In der Regel ist der Zeitanteil, während dessen der zweite Signaleingang 23 auf den Signalausgang 24 durchgeschaltet ist, erheblich kleiner als der Zeitanteil, während dessen der erste Signaleingang 22 auf den Signalausgang 24 durchgeschaltet ist. Dies ist jedoch von untergeordneter Bedeutung.

Zum Auswerten der digitalen Signale Ea', Ea", Ta" weist die Auswertungsschaltung 6 in der Regel eine erste und eine zweite Filtereinrichtung 27, 28 auf. Die beiden Filtereinrichtungen 27, 28 können beispielsweise als Tiefpassfilter ausgebildet sein. Mittels der Filtereinrichtungen 27, 28 ermittelt die Auswertungsschaltung 6 anhand der digitalen Signale Ea', Ea", Ta" jeweilige gefilterte Signale F', F". Eines der gefilterten Signale F', F" - vorzugsweise das gefilterte Signal F' - wird über das Bussystem 2' an die Zentraleinheit 2 übermittelt.

Die Auswertungsschaltung 6 weist weiterhin in der Regel eine erste Vergleichseinrichtung 29 auf. Die erste Vergleichseinrichtung 29 ist aktiv, wenn und solange der zweite Analog-Digital-Konverter 11 das digitale Signal Ea" ausgibt. Der ersten Vergleichseinrichtung 29 werden die gefilterten Signale F', F" zugeführt. In der ersten Vergleichseinrichtung 29 werden die gefilterten Signale F', F" miteinander verglichen. Sofern sich eine nennenswerte Abweichung ergibt, wird eine entsprechende Alarmmeldung A über das Bussystem 2' an die Zentraleinheit 2 übermittelt. Anderenfalls wird die Alarmmeldung A nicht abgegeben. Durch das Abgeben der Alarmmeldung A erst bei einer nennenswerten Abweichung können insbesondere geringfügige Abweichungen der digitalen Signale Ea', Ea", die sich aufgrund von Bauelemente-Toleranzen oder unterschiedlichen Abtastzeitpunkte ergeben können, berücksichtigt werden.

Die Auswertungsschaltung 6 weist weiterhin in der Regel eine zweite Vergleichseinrichtung 30 auf. Die zweite Vergleichseinrichtung 30 ist aktiv, wenn und solange der zweite Analog-Digital-Konverter 11 das digitale Signal Ta" ausgibt. Der zweiten Vergleichseinrichtung 30 werden das gefilterte Signal F" und das Testsignal T zugeführt. In der zweiten Vergleichseinrichtung 30 werden das gefilterte Signal F" und das Testsignal T miteinander verglichen. Sofern sich eine nennenswerte Abweichung ergibt, wird eine entsprechende Alarmmeldung A' über das Bussystem 2' an die Zentraleinheit 2 übermittelt. Anderenfalls wird die Alarmmeldung A' nicht abgegeben.

In vielen Fällen erfolgt über die Eingangsanschlüsse 9a auch eine unidirektionale oder bidirektionale Übermittlung digitaler Signale von der Steuer- und Auswertungseinrichtung 5 zum Sensor 19 und/oder zurück. Diese Art der Übermittlung ist Fachleuten unter dem Begriff HART (= highway addressable remote transceiver) bekannt. Im Rahmen von HART wird eine logische null mit einer ersten Frequenz codiert, beispielsweise mit 1,2 kHz, eine logische eins mit einer zweiten Frequenz, beispielsweise 2,2 kHz (sogenanntes FSK = frequency shift keying). Durch die unidirektionale oder bidirektionale Übermittlung digitaler Signale von der Steuer- und Auswertungseinrichtung 5 zum Sensor 19 und/oder zurück ist beispielsweise eine Konfiguration und/oder Überwachung des Sensors 19 möglich.

Um eine Übermittlung vom Sensor 19 zur Steuer- und Auswertungseinrichtung 5 zu realisieren, kann die Steuer- und Auswertungseinrichtung 5 für den Eingangskanal 4a eine Empfangseinrichtung 31 aufweisen. Die Empfangseinrichtung 31 ist in diesem Fall mit der Ausgangsseite des ersten oder des zweiten Koppelelements 12, 13 verbunden. Die Empfangseinrichtung 31 kann durch geeignete Frequenzfilterung aus dem entsprechenden digitalen Signal Ea', Ea" das frequenzcodierte Empfangssignal ausfiltern.

Um eine Übermittlung von der Steuer- und Auswertungseinrichtung 5 zum Sensor 19 zu realisieren, weist die Steuer- und Auswertungseinrichtung 5 für den Eingangskanal 4a eine Sendeeinrichtung 32 auf. Die Sendeeinrichtung 32 ist über das bereits erwähnte fünfte Koppelelement 20 mit den Eingangsanschlüssen 9a verbunden. Die Sendeeinrichtung 32 speist dadurch in das analoge Eingangssignal Ea ein frequenzkodiertes Sendesignal ein. Soweit erforderlich, kann zwischen dem fünften Koppelelement 20 und den Eingangsanschlüssen 9a eine zweite Verstärker- und Umsetzeinrichtung 33 angeordnet sein.

Die Auswertungsschaltung 6, der Testsignalgenerator 7, der Umschaltsignalgenerator 8, die Empfangseinrichtung 31 und die Sendeeinrichtung 32 sind in einer gestrichelten Umrahmung angeordnet. Die innerhalb dieser Umrahmung angeordneten Elemente sind in der Steuer- und Auswertungseinrichtung 5 individuell für den jeweiligen Eingangskanal 4a bis 4d vorhanden. In analoger Weise sind auch die Analog-Digital-Konverter 10, 11, die Umschalteinrichtung 16 sowie gegebenenfalls die Strom-Spannung-Wandler 17, 18 und die Verstärker- und Umsetzeinrichtungen 26, 33 individuell für den jeweiligen Eingangskanal 4a bis 4d vorhanden. Gleiches gilt für das erste bis vierte Koppelelement 12 bis 15 und gegebenenfalls auch für das fünfte Koppelelement 20.

Die Baugruppe 3c weist in der Regel weiterhin eine erste Stromversorgungseinrichtung 34 auf. Die erste Stromversorgungseinrichtung 34 versorgt die Steuer- und Auswertungseinrichtung 5 mit elektrischer Energie. Die erste Stromversorgungseinrichtung 34 ist über das bereits erwähnte sechste Koppelelement 21 mit einer zweiten Stromversorgungseinrichtung 35 verbunden. Die zweite Stromversorgungseinrichtung 35 wird also über das sechste Koppelelement 21 gespeist. Die zweite Stromversorgungseinrichtung 35 versorgt den ersten und den zweiten Analog-Digital-Konverter 10, 11 zumindest des Eingangskanals 4a mit elektrischer Energie. Soweit erforderlich, werden über die zweite Stromversorgungseinrichtung 35 auch die weiteren Elemente des jeweiligen Eingangskanals 9a mit elektrischer Energie versorgt. Dies betrifft insbesondere die Umschalteinrichtung 16 sowie, sofern sie vorhanden sind, die Strom-Spannung-Wandler 17, 18 und die Verstärker- und Umsetzeinrichtungen 26, 33.

In der Regel versorgt die zweite Stromversorgungseinrichtung 35 auch die entsprechenden Elemente der anderen Eingangskanäle 4b bis 4d. Die jeweilige Versorgung der einzelnen Eingangskanäle 4a bis 4d kann von Eingangskanal 4a bis 4d zu Eingangskanal 4a bis 4d separat und potenzialgetrennt erfolgen.

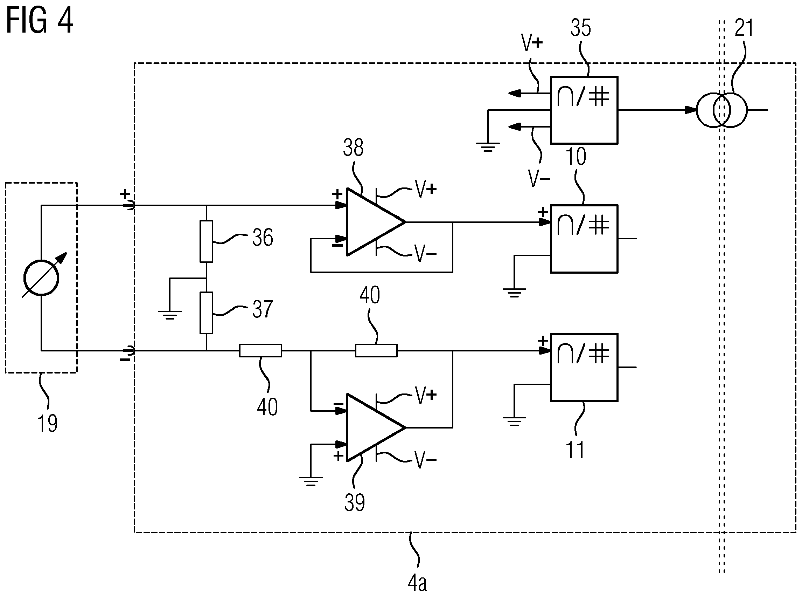

FIG 4 zeigt eine mögliche Ausgestaltung der Analogseite des Eingangskanals 4a, wobei aus Gründen der Übersichtlichkeit die Umschalteinrichtung 16 nicht mit dargestellt ist. Für die anderen Eingangskanäle 4b bis 4d gelten wieder analoge Ausführungen.

Im Rahmen der Ausgestaltung gemäß FIG 4 ist das Eingangssignal Ea ein Stromsignal. Gemäß FIG 4 stellt die zweite Stromversorgungseinrichtung 35 für den Eingangskanal 4a ein positives und ein negatives Potenzial V+, V- sowie ein Referenzpotenzial (angedeutet durch das Erde-Symbol) bereit. Die beiden Strom-Spannung-Wandler 17, 18 sind vorhanden und bestehen jeweils aus einem Eingangswiderstand 36, 37 und einem nachgeordneten Operationsverstärker 38, 39. Einer der beiden Operationsverstärker 38, 39 ist mit Beschaltungswiderständen 40 geschaltet. Die Beschaltungswiderstände 40 sind vorzugsweise - aber nicht zwingend - gleich groß.

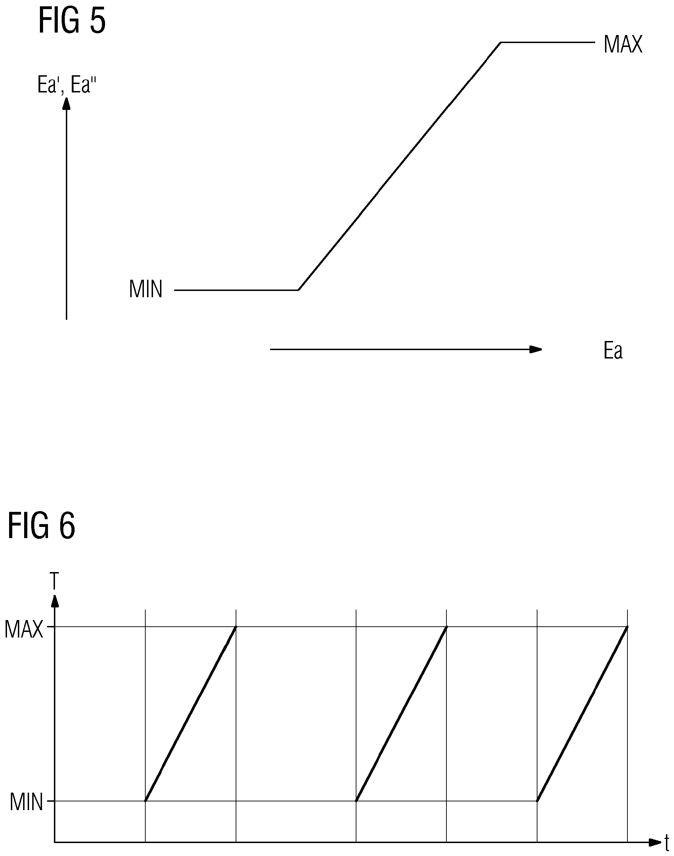

Das von dem ersten Analog-Digital-Konverter 10 ausgegebene digitale Signal Ea' ist entsprechend der Darstellung in FIG 5 proportional zu dem analogen Eingangssignal Ea. Die im Rahmen der Digitalisierung auftretende Quantisierung des digitalen Signals Ea' kann in diesem Zusammenhang vernachlässigt werden. Das digitale Signal Ea' ist jedoch nach oben durch einen Maximalwert MAX und nach unten durch einen Minimalwert MIN begrenzt. Das von dem ersten Analog-Digital-Konverter 10 ausgegebene digitale Signal Ea' liegt daher stets in dem durch den Minimalwert MIN und den Maximalwert MAX begrenzten Wertebereich. Der mögliche Wertebereich des digitalen Signals Ea' ist daher vorbestimmt. Analoge Ausführungen gelten entsprechend der Darstellung in FIG 5 auch für das von dem zweiten Analog-Digital-Konverter 11 ausgegebene digitale Signal Ea" .

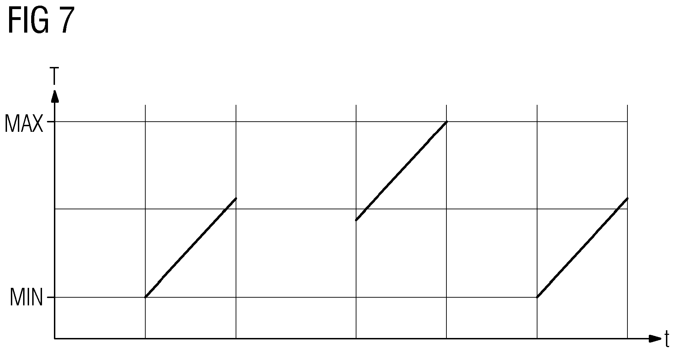

Der Testsignalgenerator 7 ist entsprechend der Darstellung in den FIG 6 und 7 derart ausgebildet, dass das Testsignal T als Funktion der Zeit t zyklisch den gesamten vorbestimmten Wertebereich durchläuft. Dadurch wird der zweite Analog-Digital-Konverter 11 zyklisch in seinem gesamten zulässigen Wertebereich getestet.

Es ist möglich, dass der Testsignalgenerator 7 und der Umschaltsignalgenerator 8 derart aufeinander abgestimmt sind, dass (nach einem entsprechenden Durchschalten des zweiten Signaleingangs 23 auf den Signalausgang 24) das Testsignal T über den zweiten Signaleingang 23 dem zweiten Analog-Digital-Konverter 11 zugeführt wird, sodann das Testsignal T den gesamten vorbestimmten Wertebereich durchläuft und erst danach - nachdem also das Testsignal T den gesamten vorbestimmten Wertebereich durchlaufen hat - dem zweiten Analog-Digital-Konverter 11 wieder das analoge Eingangssignal Ea zugeführt wird. Diese zeitliche Abfolge ist in FIG 6 dargestellt. Die entsprechenden Umschaltzeitpunkte sind in FIG 6 durch vertikale gestrichelte Linien angedeutet.

Alternativ ist es möglich, dass der Testsignalgenerator 7 und der Umschaltsignalgenerator 8 derart aufeinander abgestimmt sind, dass entsprechend der Darstellung in FIG 7 zwar zunächst das Testsignal T über den zweiten Signaleingang 23 dem zweiten Analog-Digital-Konverter 11 zugeführt wird, das Testsignal T sodann jedoch nur einen Teil des gesamten vorbestimmten Wertebereichs durchläuft. Nach dem Durchlaufen dieses Teils des vorbestimmten Wertebereichs wird die Umschalteinrichtung 16 wieder umgeschaltet und dadurch wieder das analoge Eingangssignal Ea dem zweiten Analog-Digital-Konverter 11 zugeführt.

Das Durchschalten des Testsignals T und des analogen Eingangssignals Ea erfolgt, wie bereits erwähnt alternierend. Bei einem späteren erneuten Durchschalten des Testsignals T durchläuft das Testsignal T somit wieder nur einen Teil des gesamten vorbestimmten Wertebereichs. Der nunmehr durchlaufende Teil des gesamten vorbestimmten Wertebereichs ist entsprechend der Darstellung in FIG 7 jedoch ein anderer Teil als der zuvor durchlaufene Teil. Es ist somit möglich, beim jeweiligen Durchschalten des Testsignals T sequenziell nach und nach den gesamten vorbestimmten Wertebereich zu durchlaufen. Auch in FIG 7 sind - analog zu FIG 6 - die entsprechenden Umschaltzeitpunkte durch vertikale gestrichelte Linien angedeutet.

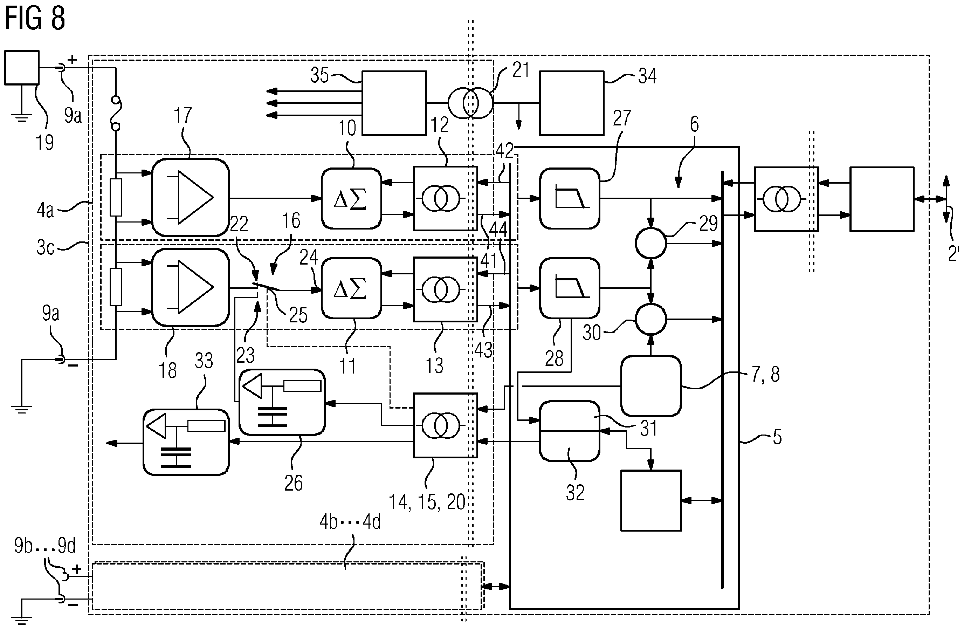

Die Analog-Digital-Wandler 10, 11 können nach Bedarf ausgebildet sein. Beispielsweise ist es entsprechend der Darstellung in FIG 8 möglich, dass der jeweilige erste Analog-Digital-Konverter 10 als Delta-Sigma-Modulator ausgebildet ist. Die Delta-Sigma-Modulation ist dem Fachmann geläufig. Es kann beispielsweise auf die entsprechenden Einträge in der deutschen und der englischen Wikipedia verwiesen werden.

Im Falle einer Delta-Sigma-Modulation weist das erste Koppelelement 12 einen Vorwärtskanal 41 auf. Der Vorwärtskanal 41 dient der Übertragung des digitalen Signals Ea'. Weiterhin weist das erste Koppelelement 12 einen Rückwärtskanal 42 auf. Der Rückwärtskanal 42 dient der Übertragung eines Taktsignals CLK von der Auswertungsschaltung 6 zum ersten Analog-Digital-Konverter 10.

Die obenstehend in Verbindung mit dem ersten Analog-Digital-Konverter 10 und dem ersten Koppelelement 12 erläuterten Ausgestaltungen sind in analoger Weise auch bei dem zweiten Analog-Digital-Konverter 11 realisierbar. In diesem Fall weist das zweite Koppelelement 13 nicht nur einen Vorwärtskanal 43, sondern zusätzlich auch einen Rückwärtskanal 44 auf.

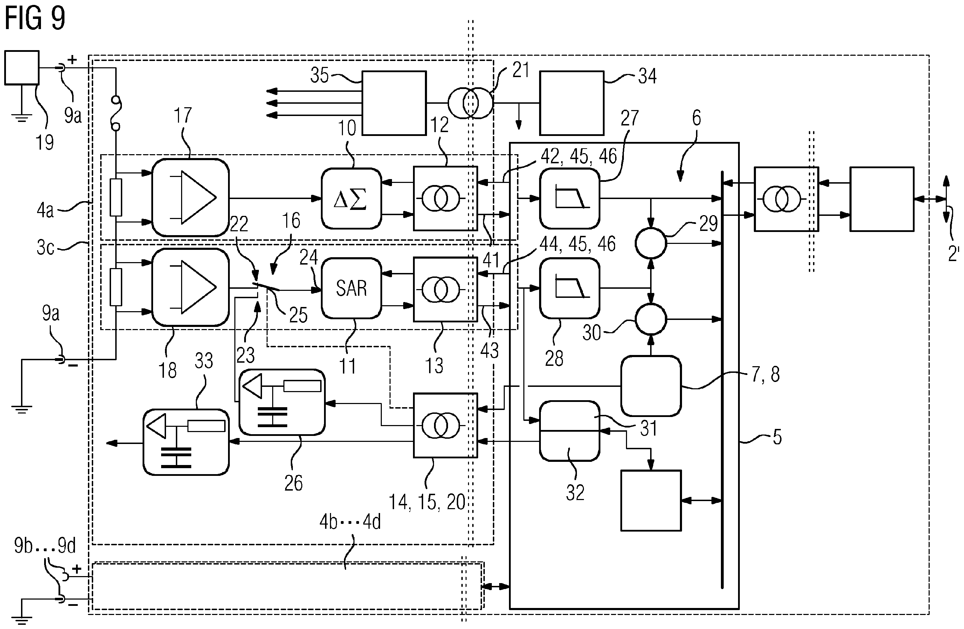

Der erste und der zweite Analog-Digital-Konverter 10, 11 können gleichartig ausgebildet sein. Bei der Ausgestaltung gemäß FIG 8 ist dies beispielsweise der Fall. Alternativ können der erste und der zweite Analog-Digital-Konverter 10, 11 diversitär ausgebildet sein. Eine mögliche diversitäre Ausgestaltung wird nachfolgend in Verbindung mit FIG 9 erläutert.

Bei der Ausgestaltung gemäß FIG 9 ist einer der beiden Analog-Digital-Konverter 10, 11 - hier der erste Analog-Digital-Konverter 10 - als Delta-Sigma-Modulator ausgebildet. Die obigen Ausführungen zu FIG 8 zur Ausgestaltung des ersten Analog-Digital-Konverters 10 und des ersten Koppelelements 12 sind analog anwendbar.

Der andere der beiden Analog-Digital-Konverter 10, 11 - hier der zweite Analog-Digital-Konverter 11 - ist anders ausgebildet. Beispielsweise kann der zweite Analog-Digital-Konverter 11 entsprechend der Darstellung in FIG 9 als SAR-Analog-Digital-Konverter ausgebildet sein. Der Begriff "SAR" steht für successive approximation register und hat für den Fachmann auf dem Gebiet von Analog-Digital-Konvertern eine feste Bedeutung. Es kann beispielsweise auf den Eintrag "successive approximation ADC" in der englischen Wikipedia verwiesen werden.

Im Falle der entsprechenden Ausgestaltung weist das entsprechende Koppelelement - hier das Koppelelement 13 - den Vorwärtskanal 43 auf. Der Vorwärtskanal 43 dient der Übertragung des digitalen Signals Ea". Weiterhin weist das zweite Koppelelement 13 den Rückwärtskanal 44 auf. Der Rückwärtskanal 44 dient der Übertragung des Taktsignals CLK von der Auswertungsschaltung 6 zum zweiten Analog-Digital-Konverter 11. Weiterhin weist das zweite Koppelelement 13 zwei weitere Rückwärtskanäle 45, 46 auf. Diese beiden Rückwärtskanäle 45, 46 dienen der Übertragung eines Konfigurationssignals CONFIG und eines Datenrahmensignals FRAME von der Auswertungsschaltung 6 zum zweiten Analog-Digital-Konverter 11.

Es sind auch andere Ausgestaltungen der Analog-Digital-Konverter 10, 11 möglich. Falls einer der beiden Analog-Digital-Konverter 10, 11 als Delta-Sigma-Modulator ausgebildet ist, muss also der andere der beiden Analog-Digital-Konverter 10, 11 nicht notwendigerweise als SAR-Analog-Digital-Konverter ausgebildet sein. Ebenso muss in dem Fall, dass einer der beiden Analog-Digital-Konverter 10, 11 als SAR-Analog-Digital-Konverter ausgebildet ist, der andere der beiden Analog-Digital-Konverter 10, 11 nicht notwendigerweise als Delta-Sigma-Modulator ausgebildet sein. Entscheidend ist lediglich, dass die beiden Analog-Digital-Konverter 10, 11 verschiedenartig, also diversitär, ausgebildet sind.

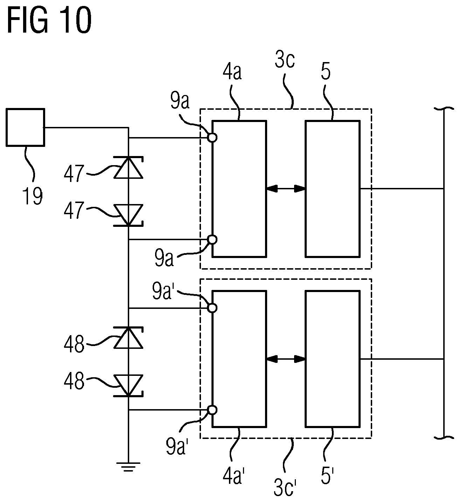

Mit den bisher erläuterten Ausgestaltungen der Eingangskanäle 4a bis 4d und der Steuer- und Auswertungseinrichtung 5 können ohne weiteres die Sicherheitsniveaus SIL 1 und SIL 2 gemäß der IEC 61508 erreicht werden. Um auch das Sicherheitsniveau SIL 3 der IEC 61508 zu erreichen, kann beispielsweise entsprechend der Darstellung in FIG 10 vorgesehen sein, mehreren Eingangskanälen 4a bis 4d dasselbe analoge Eingangssignal zuzuführen. Beispielsweise kann das analoge Eingangssignal Ea sowohl dem Eingangskanal 4a als auch einem Eingangskanal 4a' einer weiteren Baugruppe 3c' zugeführt werden. Um in einem derartigen Fall - beispielsweise, weil eine der Baugruppen 3c, 3c' defekt ist - die Baugruppen 3c, 3c' einzeln wechseln zu können, und dennoch über die jeweils andere Baugruppe 3c', 3c weiterhin das Eingangssignal Ea zu erhalten, können eingangsseitig der Eingangseinschlüsse 9a, 9a' Schaltungen mit Zenerdioden 47, 48 angeordnet sein. In diesem Fall wird bei einem Entfernen beispielsweise der Baugruppe 3c das von dem Sensor 19 abgegebene analoge Eingangssignal Ea über die Schaltung mit den Zenerdioden 47 geführt. Wenn die Baugruppe 3c hingegen vorhanden ist, wird das von dem Sensor 19 abgegebene analoge Eingangssignal Ea über die Eingangsanschlüsse 9a geführt. Die Schaltung mit den Zenerdioden 47 ist in diesem Fall inaktiv. Analoge Ausführungen gelten für die Baugruppe 3c', deren Eingangskanal 4a', dessen Eingangsanschlüsse 9a' und die zugehörige Schaltung mit den Zenerdioden 48. Mit dem Bezugszeichen 5' ist die Steuer- und Auswertungsschaltung der Baugruppe 3c' bezeichnet.

Die obenstehend in Verbindung mit FIG 10 erläuterte Vorgehensweise kann ohne weiteres auch auf Ausgestaltungen mit mehr als zwei Eingangskanäle 4a, 4a' erweitert werden. Zusammengefasst betrifft die vorliegende Erfindung somit folgenden Sachverhalt:
Eine Baugruppe 3c einer speicherprogrammierbaren Steuerung weist mehrere analoge Eingangskanäle 4a bis 4d für jeweils ein analoges Eingangssignal Ea bis Ed, eine Steuer- und Auswertungseinrichtung 5 und für jeden Eingangskanal 4a bis 4d Eingangsanschlüsse 9a bis 9d zum Zuführen des jeweiligen Eingangssignals Ea bis Ed auf. Die Baugruppe 3c weist für jeden Eingangskanal 4a bis 4d zwei Analog-Digital-Konverter 10, 11, mindestens vier Koppelelemente 12 bis 15 und eine Umschalteinrichtung 16 auf. Die Steuer- und Auswertungseinrichtung 5 weist für jeden Eingangskanal 4a bis 4d eine Auswertungsschaltung 6, einen Testsignalgenerator 7 und einen Umschaltsignalgenerator 8 auf. Eine Eingangsseite des einen Analog-Digital-Konverters 10 ist direkt oder indirekt mit den Eingangsanschlüssen 9a bis 9d verbunden, eine Ausgangsseite dieses Analog-Digital-Konverters 10 über ein Koppelelement 12 mit der Auswertungsschaltung 6. Die Umschalteinrichtung 16 weist zwei Signaleingänge 22, 23, einen Signalausgang 24 und einen Steuereingang 25 auf. Ein Signaleingang 22 ist direkt oder indirekt mit den Eingangsanschlüssen 9a bis 9d verbunden, der andere Signaleingang 23 über ein weiteres Koppelelement 14 mit dem Testsignalgenerator 7. Der Steuereingang 25 ist über ein weiteres Koppelelement 15 mit dem Umschaltsignalgenerator 8 verbunden. Der Signalausgang 24 ist mit einer Eingangsseite des anderen Analog-Digital-Konverters 11 verbunden. Eine Ausgangsseite des anderen Analog-Digital-Konverters 11 ist über ein weiteres Koppelelement 13 mit der Auswertungsschaltung 6 verbunden. Die Koppelelemente 12 bis 15 bewirken jeweils eine Potenzialtrennung.

Die vorliegende Erfindung weist viele Vorteile auf. Insbesondere ist eine einfache, kostengünstige und zuverlässige Realisierung der Baugruppe 3c möglich. Weiterhin ist trotz des immer wieder erfolgenden Durchschaltens des Testsignals T über den jeweiligen ersten Analog-Digital-Konverter 10 eine permanente Erfassung der analogen Eingangssignals Ea bis Ed möglich. Durch die beiden unterschiedlichen Alarmmeldungen A, A' kann weiterhin erkannt werden, welcher der beiden Analog-Digital-Konverter 10, 11 gegebenenfalls defekt ist. Die Realisierung einer HART-Kommunikation ist ohne weiteres möglich. Die Eingangskanäle 4a bis 4d können vollständig potenzialgetrennt voneinander und von der Steuer- und Auswertungseinrichtung 5 realisiert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 1: industrieller technischer Prozess
- 2: Zentraleinheit
- 2': Bussystem
- 3a, 3b, 3c, 3c': Baugruppen
- 4a bis 4d, 4a': Eingangskanäle
- 5, 5': Steuer- und Auswertungseinrichtungen
- 6: Auswertungsschaltung
- 7: Testsignalgenerator
- 8: Umschaltsignalgenerator
- 9a bis 9d, 9a': Eingangsanschlüsse
- 10, 11: Analog-Digital-Konverter
- 12 bis 15, 20, 21: Koppelelemente
- 16: Umschalteinrichtung
- 17, 18: Strom-Spannung-Wandler
- 19: Sensor
- 22, 23: Signaleingänge
- 24: Signalausgang
- 25: Steuereingang
- 26, 33: Verstärker- und Umsetzeinrichtungen
- 27, 28: Filtereinrichtungen
- 29, 30: Vergleichseinrichtungen
- 31: Empfangseinrichtung
- 32: Sendeeinrichtung
- 34, 35: Stromversorgungseinrichtungen
- 36, 37: Eingangswiderstände
- 38, 39: Operationsverstärker
- 40: Beschaltungswiderstände
- 41, 43: Vorwärtskanäle
- 42, 44 bis 46: Rückwärtskanäle
- 47, 48: Zenerdioden

- A, A': Alarmmeldung
- CLK: Taktsignal
- CONFIG: Konfigurationssignal
- Ea bis Ed: Eingangssignale
- Ea', Ea", Ta": digitale Signale
- F', F": gefilterte Signale
- FRAME: Datenrahmensignal
- MAX: Maximalwert
- MIN: Minimalwert
- S: Steuersignal
- T: Testsignal
- t: Zeit
- V+, V-: Potentiale

## Patentansprüche

1. Baugruppe für eine speicherprogrammierbare Steuerung,
- wobei die Baugruppe mehrere analoge Eingangskanäle (4a bis 4d) für jeweils ein analoges Eingangssignal (Ea bis Ed) aufweist,
- wobei die Baugruppe eine Steuer- und Auswertungseinrichtung (5) und für jeden Eingangskanal (4a bis 4d) - jeweils unabhängig von den anderen Eingangskanälen (4a bis 4d) - Eingangsanschlüsse (9a bis 9d) zum Zuführen des jeweiligen analogen Eingangssignals (Ea bis Ed) aufweist,
**dadurch gekennzeichnet,**
- **dass** die Baugruppe für jeden Eingangskanal (4a bis 4d) - jeweils unabhängig von den anderen Eingangskanälen (4a bis 4d) - einen ersten und einen zweiten Analog-Digital-Konverter (10, 11), ein erstes, ein zweites, ein drittes und ein viertes Koppelelement (12 bis 15) und eine Umschalteinrichtung (16) aufweist,
- **dass** die Steuer- und Auswertungseinrichtung (5) für jeden Eingangskanal (4a bis 4d) - jeweils unabhängig von den anderen Eingangskanälen (4a bis 4d) - eine Auswertungsschaltung (6), einen Testsignalgenerator (7) und einen Umschaltsignalgenerator (8) aufweist,
- **dass** eine Eingangsseite des jeweiligen ersten Analog-Digital-Konverters (10) direkt oder indirekt mit den jeweiligen Eingangsanschlüssen (9a bis 9d) und eine Ausgangsseite des jeweiligen ersten Analog-Digital-Konverters (10) über das jeweilige erste Koppelelement (12) mit der jeweiligen Auswertungsschaltung (6) verbunden ist,
- **dass** die jeweilige Umschalteinrichtung (16) einen ersten und einen zweiten Signaleingang (22, 23), einen Signalausgang (24) und einen Steuereingang (25) aufweist,
- **dass** der erste Signaleingang (22) der jeweiligen Umschalteinrichtung (16) direkt oder indirekt mit den jeweiligen Eingangsanschlüssen (9a bis 9d) verbunden ist, der zweite Signaleingang (23) der jeweiligen Umschalteinrichtung (16) über das jeweilige dritte Koppelelement (14) mit dem jeweiligen Testsignalgenerator (7) verbunden ist, der Steuereingang (25) der jeweiligen Umschalteinrichtung (16) über das jeweilige vierte Koppelelement (15) mit dem jeweiligen Umschaltsignalgenerator (8) verbunden ist und der Signalausgang (24) der jeweiligen Umschalteinrichtung (16) mit einer Eingangsseite des jeweiligen zweiten Analog-Digital-Konverters (11) verbunden ist,
- **dass** eine Ausgangsseite des jeweiligen zweiten Analog-Digital-Konverters (11) über das jeweilige zweite Koppelelement (13) mit der jeweiligen Auswertungsschaltung (6) verbunden ist und
- **dass** das jeweilige erste, das jeweilige zweite, das jeweilige dritte und das jeweilige vierte Koppelelement (12 bis 15) jeweils als eine Potenzialtrennung bewirkendes Koppelelement ausgebildet sind.

2. Baugruppe nach Anspruch 1,
**dadurchgekennzeichnet**,
dass die Steuer- und Auswertungseinrichtung (5) in einem FPGA angeordnet ist.

3. Baugruppe nach Anspruch 1 oder 2,
**dadurchgekennzeichnet**,
dass die Steuer- und Auswertungseinrichtung (5) für den jeweiligen Eingangskanal (4a bis 4d) eine jeweilige Empfangseinrichtung (31) aufweist, die mit einer Ausgangsseite des jeweiligen ersten oder des jeweiligen zweiten Koppelelements (12, 13) verbunden ist und aus einem über das jeweilige erste oder das jeweilige zweite Koppelelement (12, 13) übertragenen digitalen Signal (Ea', Ea") ein jeweiliges frequenzkodiertes Empfangssignal ausfiltert.

4. Baugruppe nach Anspruch 1, 2 oder 3,
**dadurchgekennzeichnet**,
- dass die Steuer- und Auswertungseinrichtung (5) für den jeweiligen Eingangskanal (4a bis 4d) eine jeweilige Sendeeinrichtung (32) aufweist,
- dass die jeweilige Sendeeinrichtung (32) über ein jeweiliges fünftes Koppelelement (20) mit den jeweiligen Eingangsanschlüssen (9a bis 9d) verbunden ist,
- dass die jeweilige Sendeeinrichtung (32) in das jeweilige Eingangssignal (Ea bis Ed) ein jeweiliges frequenzkodiertes Sendesignal einspeist und
- dass das jeweilige fünfte Koppelelement (20) als eine Potenzialtrennung bewirkendes Koppelelement ausgebildet ist.

5. Baugruppe nach einem der obigen Ansprüche,
**dadurchgekennzeichnet**,
- dass die Baugruppe eine erste Stromversorgungseinrichtung (34) aufweist, welche die Steuer- und Auswertungseinrichtung (5) mit elektrischer Energie versorgt,
- dass die erste Stromversorgungseinrichtung (34) über ein sechstes Koppelelement (21) mit einer zweiten Stromversorgungseinrichtung (35) verbunden ist,
- dass die zweite Stromversorgungseinrichtung (35) den ersten und den zweiten Analog-Digital-Konverter (10, 11) mindestens eines der Eingangskanäle (4a bis 4d) mit elektrischer Energie versorgt und
- dass das sechste Koppelelement (21) als eine Potenzialtrennung bewirkendes Koppelelement ausgebildet ist.

6. Baugruppe nach einem der obigen Ansprüche,
**dadurchgekennzeichnet**,
dass die jeweilige Auswertungsschaltung (6)
- eine jeweilige erste und eine jeweilige zweite Filtereinrichtung (27, 28) zum Ermitteln eines jeweiligen ersten und eines jeweiligen zweiten gefilterten Signals (F', F") anhand eines von dem jeweiligen ersten und dem jeweiligen zweiten Analog-Digital-Konverter (10, 11) ausgegebenen jeweiligen digitalen Signals (Ea', Ea", Ta") aufweist,
- eine jeweilige erste Vergleichseinrichtung (27) zum Vergleichen des jeweiligen ersten und des jeweiligen zweiten gefilterten Signals (F', F") aufweist und
- eine jeweilige zweite Vergleichseinrichtung (28) zum Vergleichen eines von dem jeweiligen Testsignalgenerator (7) ausgegebenen jeweiligen Testsignals (T) und des jeweiligen zweiten gefilterten Signals (F") aufweist.

7. Baugruppe nach einem der obigen Ansprüche,
**dadurchgekennzeichnet**,
dass ein von dem jeweiligen ersten und dem jeweiligen zweiten Analog-Digital-Konverter (10, 11) ausgegebenes jeweiliges digitales Signal (Ea', Ea") innerhalb eines jeweiligen vorbestimmten Wertebereichs liegt und dass der jeweilige Testsignalgenerator (7) derart ausgebildet ist, dass ein von dem jeweiligen Testsignalgenerator (7) ausgegebenes jeweiliges Testsignal (T) zyklisch den gesamten jeweiligen vorbestimmten Wertebereich durchläuft.

8. Baugruppe nach Anspruch 7,
**dadurchgekennzeichnet**,
dass der jeweilige Testsignalgenerator (7) und der jeweilige Umschaltsignalgenerator (8) derart aufeinander abgestimmt sind, dass
- zunächst das jeweilige Testsignal (T) über den jeweiligen zweiten Signaleingang (23) der jeweiligen Umschalteinrichtung (16) direkt oder indirekt dem jeweiligen zweiten Analog-Digital-Konverter (11) zugeführt wird,
- sodann das jeweilige Testsignal (T) den gesamten jeweiligen vorbestimmten Wertebereich durchläuft und
- erst danach wieder das jeweilige analoge Eingangssignal (Ea) direkt oder indirekt dem jeweiligen zweiten Analog-Digital-Konverter (11) zugeführt wird.

9. Baugruppe nach Anspruch 7,
**dadurchgekennzeichnet**,
dass der jeweilige Testsignalgenerator (7) und der jeweilige Umschaltsignalgenerator (8) derart aufeinander abgestimmt sind, dass
a) zunächst das jeweilige Testsignal (T) über den jeweiligen zweiten Signaleingang (23) der jeweiligen Umschalteinrichtung (16) direkt oder indirekt dem jeweiligen zweiten Analog-Digital-Konverter (11) zugeführt wird,
b) sodann das jeweilige Testsignal (T) jeweils einen Teil des gesamten jeweiligen vorbestimmten Wertebereichs durchläuft,
c) danach wieder das jeweilige analoge Eingangssignal (Ea) direkt oder indirekt dem jeweiligen zweiten Analog-Digital-Konverter (11) zugeführt wird und
d) die Schritte a) bis c) wiederholt ausgeführt werden und bei der jeweiligen Ausführung des Schrittes b) das jeweilige Testsignal (T) jeweils einen anderen Teil des gesamten jeweiligen vorbestimmten Wertebereichs durchläuft, bis das jeweilige Testsignal (T) aufgrund der wiederholten Ausführung des Schrittes b) den gesamten jeweiligen vorbestimmten Wertebereich durchlaufen hat.

10. Baugruppe nach einem der Ansprüche 1 bis 9,
**dadurchgekennzeichnet**,
- dass der jeweilige erste Analog-Digital-Konverter (10) als Delta-Sigma-Modulator ausgebildet ist und das jeweilige erste Koppelelement (12) zusätzlich zu einem Vorwärtskanal (41) zur Übertragung eines von dem jeweiligen ersten Analog-Digital-Konverter (10) abgegebenen jeweiligen digitalen Signals (Ea') einen Rückwärtskanal (42) zur Übertragung eines jeweiligen Taktsignals (CLK) von der jeweiligen Auswertungsschaltung (6) zum jeweiligen ersten Analog-Digital-Konverter (10) aufweist und/oder
- dass der jeweilige zweite Analog-Digital-Konverter (11) als Delta-Sigma-Modulator ausgebildet ist und das jeweilige zweite Koppelelement (13) zusätzlich zu einem Vorwärtskanal (43) zur Übertragung eines von dem jeweiligen zweiten Analog-Digital-Konverter (11) abgegebenen jeweiligen digitalen Signals (Ea", Ta") einen Rückwärtskanal (44) zur Übertragung eines jeweiligen Taktsignals (CLK) von der jeweiligen Auswertungsschaltung (6) zum jeweiligen zweiten Analog-Digital-Konverter (11) aufweist.

11. Baugruppe nach einem der Ansprüche 1 bis 9,
**dadurchgekennzeichnet**,
dass jeweilige erste und der jeweilige zweite Analog-Digital-Konverter (10, 11) diversitär ausgebildet sind.

12. Baugruppe nach Anspruch 11,
**dadurchgekennzeichnet**,
dass, bezogen auf den jeweiligen ersten und den jeweiligen zweiten Analog-Digital-Konverter (10, 11),
- einer (10) dieser beiden Analog-Digital-Konverter (10, 11) als Delta-Sigma-Modulator ausgebildet ist und das mit diesem Analog-Digital-Konverter (10) verbundene Koppelelement (12) zusätzlich zu einem Vorwärtskanal (41) zur Übertragung eines von diesem Analog-Digital-Konverter (10) abgegebenen digitalen Signals (Ea') einen Rückwärtskanal (42) zur Übertragung eines Taktsignals (CLK) von der jeweiligen Auswertungsschaltung (6) zu diesem Analog-Digital-Konverter (10) aufweist und/oder
- der andere (11) dieser beiden Analog-Digital-Konverter (10, 11) als SAR-Analog-Digital-Konverter ausgebildet ist und das mit diesem Analog-Digital-Konverter (11) verbundene Koppelelement (13) zusätzlich zu einem Vorwärtskanal (43) zur Übertragung eines von diesem Analog-Digital-Konverter (11) abgegebenen digitalen Signals (Ea") drei Rückwärtskanäle (44 bis 46) zur Übertragung eines Taktsignals (CLK), eines Konfigurationssignals (CONFIG) und eines Datenrahmensignals (FRAME) von der jeweiligen Auswertungsschaltung (6) zu diesem Analog-Digital-Konverter (11) aufweist.

13. Baugruppe nach einem der obigen Ansprüche,
**dadurchgekennzeichnet**,
dass das jeweilige erste, das jeweilige zweite, das jeweilige dritte und das jeweilige vierte Koppelelement (12 bis 15) als Induktivkoppler ausgebildet sind.

## Claims

1. Module for a programmable controller,
- wherein the module has a plurality of analogue input channels (4a to 4d) each for an analogue input signal (Ea to Ed),
- wherein the module has a control and evaluation device (5) and for each input channel (4a to 4d) - in each case independently of the other input channels (4a to 4d) - input terminals (9a, 9d) for supplying the respective analogue input signal (Ea to Ed),
**characterised in that**
- the module has for each input channel (4a to 4d) - in each case independently of the other input channels (4a to 4d) - a first and a second analogue-to-digital converter (10, 11), a first, a second, a third and a fourth coupling element (12 to 15) and a switchover device (16),
- the control and evaluation device (5) has for each input channel (4a to 4d) - in each case independently of the other input channels (4a to 4d) - an evaluation circuit (6), a test signal generator (7) and a switching signal generator (8),
- an input side of the respective first analogue-to-digital converter (10) is connected directly or indirectly with the respective input terminals (9a to 9d) and an output side of the respective first analogue-to-digital converter (10) is connected via the respective first coupling element (12) with the respective evaluation circuit (6),
- the respective switchover device (16) has a first and a second signal input (22, 23), a signal output (24) and a control input (25),
- the first signal input (22) of the respective switchover device (16) is connected directly or indirectly with the respective input terminals (9a to 9d), the second signal input (23) of the respective switchover device (16) is connected via the respective third coupling element (14) with the respective test signal generator (7), the control input (25) of the respective switchover device (16) is connected via the respective fourth coupling element (15) with the respective switching signal generator (8) and the signal output (24) of the respective switchover device (16) is connected with an input side of the respective second analogue-to-digital converter (11),
- an output side of the respective second analogue-to-digital converter (11) is connected via the respective second coupling element (13) with the respective evaluation circuit (6) and
- the respective first, the respective second, the respective third and the respective fourth coupling elements (12 to 15) are each embodied as a coupling element which brings about electrical isolation.

2. Module according to claim 1,
**characterised in that**
the control and evaluation device (5) is arranged in an FPGA.

3. Module according to claim 1 or 2,
**characterised in that**
the control and evaluation device (5) has a respective receiver (31) for the respective input channel (4a to 4d), which receiver is connected with an output side of the respective first or the respective second coupling element (12, 13) and filters a respective frequency-encoded receive signal from a digital signal (Ea', Ea") transmitted via the respective first or the respective second coupling element (12, 13).

4. Module according to claim 1, 2 or 3,
**characterised in that**
- the control and evaluation device (5) has a respective transmitter (32) for the respective input channel (4a to 4d),
- the respective transmitter (32) is connected via a respective fifth coupling element (20) with the respective input terminals (9a to 9d),
- the respective transmitter (32) feeds a respective frequency-encoded transmit signal into the respective input signal (Ea to Ed) and
- the respective fifth coupling element (20) is embodied as a coupling element which brings about electrical isolation.

5. Module according to one of the preceding claims,
**characterised in that**
- the module has a first power supply device (34), which supplies the control and evaluation device (5) with electrical energy,
- the first power supply device (34) is connected with a second power supply device (35) via a sixth coupling element (21),
- the second power supply device (35) supplies the first and second analogue-to-digital converters (10, 11) of at least one of the input channels (4a to 4d) with electrical energy and
- the sixth coupling element (21) is embodied as a coupling element which brings about electrical isolation.

6. Module according to one of the preceding claims,
**characterised in that**
the respective evaluation circuit (6)
- has a respective first and a respective second filter device (27, 28) for determining a respective first and a respective second filtered signal (F', F") on the basis of a respective digital signal (Ea', Ea", Ta") output by the respective first and the respective second analogue-to-digital converters (10, 11),
- has a respective first comparator (27) for comparing the respective first and the respective second filtered signal (F', F") and
- has a respective second comparator (28) for comparing a respective test signal (T) output by the respective test signal generator (7) and the respective second filtered signal (F").

7. Module according to one of the preceding claims,
**characterised in that**
a respective digital signal (Ea', Ea") output by the respective first and the respective second analogue-to-digital converter (10, 11) lies within a respective predetermined range of values and **in that** the respective test signal generator (7) is embodied such that a respective test signal (T) output by the respective test signal generator (7) runs cyclically through the respective full predetermined range of values.

8. Module according to claim 7,
**characterised in that**
the respective test signal generator (7) and the respective switching signal generator (8) are tuned to one another in such a way that
- firstly the respective test signal (T) is fed via the respective second signal input (23) of the respective switchover device (16) directly or indirectly to the respective second analogue-to-digital converter (11),
- then the respective test signal (T) runs through the respective full predetermined range of values and
- only thereafter is the respective analogue input signal (Ea) again fed directly or indirectly to the respective second analogue-to-digital converter (11).

9. Module according to claim 7,
**characterised in that**
the respective test signal generator (7) and the respective switching signal generator (8) are tuned to one another in such a way that
a) firstly the respective test signal (T) is fed via the respective second signal input (23) of the respective switchover device (16) directly or indirectly to the respective second analogue-to-digital converter (11),
b) then the respective test signal (T) runs in each case through part of the respective full predetermined range of values,
c) thereafter the respective analogue input signal (Ea) is again fed directly or indirectly to the respective second analogue-to-digital converter (11) and
d) steps a) to c) are performed repeatedly and when step b) is respectively performed the respective test signal (T) in each case runs through a different part of the respective full predetermined range of values, until the respective test signal (T) has, as a result of repeating step b), run through the respective full predetermined range of values.

10. Module according to one of claims 1 to 9,
**characterised in that**
- the respective first analogue-to-digital converter (10) is embodied as a delta-sigma modulator and the respective first coupling element (12) has not only a forward channel (41) for transmitting a respective digital signal (Ea') output by the respective first analogue-to-digital converter (10) but also a backward channel (42) for transmitting a respective clock signal (CLK) from the respective evaluation circuit (6) to the respective first analogue-to-digital converter (10) and/or
- the respective second analogue-to-digital converter (11) is embodied as a delta-sigma modulator and the respective second coupling element (13) has not only a forward channel (43) for transmitting a respective digital signal (Ea", Ta") output by the respective second analogue-to-digital converter (11) but also a backward channel (44) for transmitting a respective clock signal (CLK) from the respective evaluation circuit (6) to the respective second analogue-to-digital converter (11).

11. Module according to one of claims 1 to 9,
**characterised in that**
the respective first and the respective second analogue-to-digital converter (10, 11) are diversely embodied.

12. Module according to claim 11,
**characterised in that**,
based on the respective first and the respective second analogue-to-digital converter (10, 11),
- one (10) of these two analogue-to-digital converters (10, 11) is embodied as a delta-sigma modulator and the coupling element (12) connected with this analogue-to-digital converter (10) has not only a forward channel (41) for transmitting a digital signal (Ea') output by this analogue-to-digital converter (10) but also a backward channel (42) for transmitting a clock signal (CLK) from the respective evaluation circuit (6) to this analogue-to-digital converter (10) and/or
- the other one (11) of these two analogue-to-digital converters (10, 11) is embodied as an SAR analogue-to-digital converter and the coupling element (13) connected with this analogue-to-digital converter (11) has not only a forward channel (43) for transmitting a digital signal (Ea") output by this analogue-to-digital converter (11) but also three backward channels (44 to 46) for transmitting a clock signal (CLK), a configuration signal (CONFIG) and a data frame signal (FRAME) from the respective evaluation circuit (6) to this analogue-to-digital converter (11).

13. Module according to one of the preceding claims,
**characterised in that**,
the respective first, the respective second, the respective third and the respective fourth coupling elements (12 to 15) are embodied as inductive couplers.

## Revendications

1. Module d'automate programmable,
- dans lequel le module a plusieurs canaux (4a à 4d) analogiques d'entrée pour respectivement un signal (Ea à Ed) analogique d'entrée,
- dans lequel le module a un dispositif (5) de commande et d'analyse et, pour chaque canal (4a à 4d) d'entrée - indépendamment respectivement des autres canaux (4a à 4d) d'entrée - des bornes (9a à 9d) d'entrée, pour l'acheminement du signal (Ea à Ed) analogique d'entrée respectif,
**caractérisé**
- **en ce que** le module a, pour chaque canal (4a à 4d) d'entrée - indépendamment respectivement des autres canaux (4a à 4d) d'entrée - un premier et un deuxième convertisseur (10, 11) analogique - numérique, un premier, un deuxième, un troisième et un quatrième élément (12 à 15) de couplage et un dispositif (16) de commutation,
- **en ce que** le dispositif (5) de commande et d'analyse a, pour chaque canal (4a à 4d) d'entrée - indépendamment respectivement des autres canaux (4a à 4d) d'entrée - un circuit (6) d'analyse, un générateur (7) de signal de test et un générateur (8) de signal de commutation,
- **en ce qu'**un côté d'entrée du premier convertisseur (10) analogique - numérique respectif est relié directement ou indirectement aux bornes (9a à 9d) d'entrée respectives et un côté de sortie du premier convertisseur (10) analogique - numérique respectif est relié au circuit (6) respectif d'analyse par le premier élément (12) respectif de couplage,
- **en ce que** le dispositif (16) respectif de commutation a une première et une deuxième entrée (22, 23) du signal, une sortie (24) du signal et une entrée (25) de commande,
- **en ce que** la première entrée (22) du signal du dispositif (16) respectif de commutation est reliée directement ou indirectement aux bornes (9a à 9d) d'entrée respectives, la deuxième entrée (23) du signal du dispositif (16) respectif de commutation est reliée au générateur (7) de signal de test respectif par le troisième élément (14) de couplage respectif, l'entrée (25) de commande du dispositif (16) respectif de commutation est reliée au générateur (8) de signal de commutation respectif par le quatrième élément (15) de couplage respectif et la sortie (24) du signal du dispositif (16) respectif de commutation est reliée à un côté d'entrée du deuxième convertisseur (11) analogique - numérique respectif,
- **en ce qu'**un côté de sortie du deuxième convertisseur (11) analogique - numérique respectif est relié au circuit (6) respectif d'analyse par le deuxième élément (13) de couplage respectif et
- **en ce que** le premier respectif, le deuxième respectif, le troisième respectif et le quatrième respectif élément (12 à 15) de couplage sont constitués chacun sous la forme d'un élément de couplage provoquant une séparation de potentiel.

2. Module suivant la revendication 1,
**caractérisé en ce que**
le dispositif (5) de commande et d'analyse est disposé dans un FPGA.

3. Module suivant la revendication 1 ou 2,
**caractérisé en ce que**
le dispositif (5) de commande et d'analyse a, pour le canal (4a à 4d) respectif d'entrée, un dispositif (31) respectif de réception, qui est relié à un côté de sortie du premier respectif, du deuxième respectif élément (12, 13) de couplage et filtre un signal de réception respectif codé en fréquence, dans un signal (Ea', Ea") numérique transmis par le premier respectif ou par le deuxième respectif élément (12, 13) de couplage.

4. Module suivant la revendication 1, 2 ou 3,
**caractérisé**
- **en ce que** le dispositif (5) de commande et d'analyse a, pour le canal (4a à 4d) respectif d'entrée, un dispositif (32) respectif d'émission,
- **en ce que** le dispositif (32) respectif d'émission est relié aux bornes (9a à 9d) d'entrée respectives par un cinquième respectif élément (20) de couplage,
- **en ce que** le dispositif (32) respectif d'émission injecte, dans le signal (Ea à Ed) respectif d'entrée, un signal d'émission respectif codé en fréquence et
- **en ce que** le cinquième élément (20) respectif de couplage est constitué sous la forme d'un élément de couplage provoquant une séparation de potentiel.

5. Module suivant l'une des revendications précédentes,
**caractérisé**
- **en ce que** le module a un premier dispositif (34) d'alimentation en courant, qui alimente le dispositif (5) de commande et d'analyse en énergie électrique,
- **en ce que** le premier dispositif (34) d'alimentation en courant est relié à un deuxième dispositif (35) d'alimentation en courant par un sixième élément (21) de couplage,
- **en ce que** le deuxième dispositif (35) d'alimentation en courant alimente en énergie électrique le premier et le deuxième convertisseur (10, 11) analogique - numérique d'au moins l'un des canaux (4a à 4d) d'entrée et
- **en ce que** le sixième élément (21) de couplage est constitué sous la forme d'un élément de couplage provoquant une séparation de potentiel.

6. Module suivant l'une des revendications précédentes,
**caractérisé en ce que**
le circuit (6) respectif d'analyse
- a un premier respectif et un deuxième respectif dispositif (27, 28) de filtrage, pour la détermination d'un premier respectif et d'un deuxième respectif signal (F', F") filtré, à l'aide d'un signal (Ea', Ea", Ta") numérique respectif émis par le premier respectif et le deuxième respectif convertisseur (10, 11) analogique - numérique,
- a un premier dispositif (27) de comparaison respectif pour la comparaison du premier respectif et du deuxième respectif signal (F', F") filtré et
- a un deuxième dispositif (28) de comparaison respectif pour la comparaison d'un signal (T) respectif de test amis par le générateur (7) de respectif de signal de test et du deuxième signal (F") filtré respectif.

7. Module suivant l'une des revendications précédentes,
**caractérisé en ce que**
un signal (Ea', Ea") numérique respectif, émis par le premier respectif et le deuxième respectif convertisseur (10, 11) analogique - numérique, se trouve dans une plage de valeurs respectives définie à l'avance et **en ce que** le générateur (7) respectif de signal de test est constitué, de manière à ce qu'un signal (T) de test respectif, émis par le générateur (7) respectif de signal de test, parcourt cycliquement toute la plage respective de valeurs définie à l'avance.

8. Module suivant la revendication 7,
**caractérisé**
**en ce que** le générateur (7) respectif de signal de test et le générateur (8) respectif de signal de commutation sont accordés l'un à l'autre, de manière à ce que
- d'abord le signal (T) de test respectif soit acheminé par la deuxième entrée (23) respective du signal du dispositif (16) respectif de commutation directement ou indirectement au deuxième convertisseur (11) analogique - numérique respectif,
- puis, que le signal (T) de test respectif parcourt toute la plage respective de valeurs déterminée à l'avance et
- ensuite à nouveau seulement, le signal (Ea) d'entrée analogique respective soit acheminé directement ou indirectement au deuxième convertisseur (11) analogique - numérique respectif.

9. Module suivant la revendication 7,
**caractérisé**
**en ce que** le générateur (7) respectif de signal de test et le générateur (8) respectif de signal de commutation sont adaptés l'un à l'autre, de manière à ce que
a) d'abord le signal (T) respectif de test soit acheminé par la deuxième entrée (23) respective du signal du dispositif (16) respectif de commutation directement ou indirectement au deuxième convertisseur (11) analogique - numérique respectif,
b) puis, que le signal (T) respectif de test parcourt respectivement une partie de toute la plage respective de valeurs définie à l'avance,
c) ensuite à nouveau, le signal (Ea) d'entrée analogique respectif soit acheminé directement ou indirectement au deuxième convertisseur (11) analogique respectif et
d) les stades a) à c) soient exécutés de manière répétée et, lors de la réalisation respective du stade b), le signal (T) respectif de test parcourt respectivement une autre partie de toute la plage de valeurs définie à l'avance respective jusqu'à ce que le signal (T) respectif de test, en raison de l'exécution répétée du stade b), ait parcouru toute la plage de valeurs définie à l'avance respective.

10. Module suivant l'une des revendications 1 à 9,
**caractérisé**
- **en ce que** le premier convertisseur (10) analogique - numérique respectif est constitué sous la forme d'un modulateur Delta-Sigma et le premier élément (12) respectif de couplage a, en plus d'un canal (41) vers l'avant de transmission d'un signal (Ea') respectif numérique envoyé par le premier convertisseur (10) respectif analogique - numérique, un canal (42) de retour de transmission d'un signal (CLK) respectif d'horloge du circuit (6) respectif de commutation au premier convertisseur (10) analogique - numérique et/ou
- **en ce que** le deuxième convertisseur (11) analogique - numérique respectif est constitué sous la forme d'un modulateur Delta - Sigma et le deuxième élément (13) respectif de couplage a, en plus d'un canal (43) vers l'avant de transmission d'un signal (Ea", Ta") numérique respectif envoyé par le deuxième convertisseur (11) analogique - numérique respectif, un canal (44) vers l'arrière de transmission d'un signal (CLK) respectif d'horloge du circuit (6) respectif d'analyse au deuxième convertisseur (11) analogique - numérique respectif.

11. Module suivant l'une des revendications 1 à 9,
**caractérisé**
**en ce que** le premier respectif et le deuxième respectif convertisseur (10, 11) analogique - numérique sont constitués en diversité.

12. Module suivant la revendication 11,
**caractérisé**
**en ce que** rapporté au premier respectif et au deuxième respectif convertisseur (10, 11) analogique - numérique,
- l'un (10) de ces deux convertisseurs (10, 11) analogique - numérique est constitué en modulateur Delta - Sigma et l'élément (12) de couplage, relié à ce convertisseur (10) analogique - numérique a, en plus d'un canal (41) vers l'avant de transmission d'un signal (Ea') numérique envoyé par ce convertisseur (10) analogique - numérique, un canal (42) vers l'arrière de transmission d'un signal (CLK) d'horloge du circuit (6) respectif d'analyse à ce convertisseur (10) analogique - numérique et/ou
- l'autre (11) de ces deux convertisseurs (10, 11) analogique - numérique est constitué en convertisseur analogique - numérique SAR et l'élément (13) de couplage, relié à ce convertisseur (11) analogique - numérique a, en plus d'un canal (43) vers l'avant de transmission d'un signal (Ea") numérique envoyé par ce convertisseur (11) analogique - numérique, trois canaux (44 à 46) vers l'arrière de transmission d'un signal (CLK) d'horloge, d'un signal (CONFIG) de configuration et d'un signal (FRAME) de trames de données du circuit (6) respectif d'analyse à ce convertisseur (11) analogique - numérique.

13. Module suivant l'une des revendications précédentes,
**caractérisé**
**en ce que** le premier respectif, le deuxième respectif, le troisième respectif et le quatrième respectif élément (12 à 15) de couplage sont constitués sous la forme de coupleurs inductifs.
